# EUROPÄISCHE PATENTSCHRIFT

(11) **EP 0 482 232 B1**
(45) Veröffentlichungstag und Bekanntmachung des Hinweises auf die Patenterteilung: **05.06.1996**
(21) Anmeldenummer: 90120324.0
(22) Anmeldetag: 23.10.1990
(51) Int. Cl.: H01L 21/82, H01L 21/3215

(54) **Verfahren zur Herstellung einer dotierten Polyzidschicht auf einem Halbleitersubstrat**
Process for manufacturing a doped polycide layer on a semiconductor substrate
Méthode de fabrication d'une couche de polycide dopée sur un substrat semi-conducteur

(43) Veröffentlichungstag der Anmeldung: 29.04.1992
(73) Patentinhaber: SIEMENS AKTIENGESELLSCHAFT, D-80333 München (DE)
(72) Erfinder: Schwalke, Udo, Dr., Williston, VT 05495 (US); Burmester, Ralf, D-4030 Ratingen 6 (DE)

(56) Entgegenhaltungen:
- EP-A- 0 163 871
- FR-A- 2 558 010
- JOURNAL OF VACUUM SCIENCE & TECHNOLOGY B, Band 7, Nr. 1, Januar - Februar 1989, Seiten 120-126, New York, US; U. SCHWALKE et al: "Boron diffusion within TaSi2/poly-Si gates"
- Technical Digest IEDM 1988, Seiten 56-59

## Beschreibung

In hochintegrierten Halbleiterschaltungen gewinnen dotierte Polyzidschichten, das heißt zusammengesetzte Schichten aus einer dotierten Siliziumschicht, die polykristallin oder amorph ist, und einer darauf angeordneten Metallsilizidschicht, zunehmend an Bedeutung. Dotierte Polyzidschichten werden zum Beispiel in der Bipolartechnologie als Anschlußstruktur für Emitter, Basis und Kollektor und in der CMOS-Technologie als Gateelektroden verwendet.

Nach dem Stand der Technik werden dotierte Polyzidschichten unter anderem dadurch hergestellt, daß auf eine auf einem Halbleitersubstrat angeordnete dotierte Siliziumschicht, die polykristallin oder amorph ist, eine Metallschicht aufgebracht wird. Mit Hilfe einer Temperaturbehandlung reagiert ein Teil der Siliziumschicht mit der darauf angeordneten Metallschicht zu Metallsilizid. Dabei kommt es zu einer Dotierstoffabreicherung des verbleibenden Teils der Siliziumschicht. Es findet ein Rückfluß von Dotierstoff aus dem Silizium in das Metallsilizid statt. Dieser Effekt ist besonders stark, wenn Bor als Dotierstoff verwendet wird. Die Dotierstoffabreicherung wird durch eine parasitäre Metall-Dotierstoffreaktion erklärt, die während der Silizidbildung stattfindet und die zur Bildung stabiler Metall-Dotierstoffverbindungen, wie zum Beispiel TiB₂, führt.

In dem sogenannten Salicide-Prozeß, der in der CMOS-Technologie in zunehmendem Maße an Bedeutung gewinnt, macht sich die Dotierstoffabreicherung sehr negativ bemerkbar. Als Salicide-Prozeß wird die gleichzeitige Silizierung von Gateelektrode und Source/Draingebieten bei der Herstellung von MOS-Transistoren bezeichnet. Es wird in diesem Verfahren ein Metall, zum Beispiel Titan, ganzflächig auf bereits strukturierte Transistorgebiete abgeschieden. Bei geeigneter Temperaturbehandlung tritt auf den freiliegenden Siliziumflächen, das heißt der Oberfläche einer Gateelektrode aus Polysilizium oder amorphem Silizium und der Substratoberfläche in den Source/Draingebieten, die Silizidbildung ein, wohingegen auf mit Siliziumoxid oder Siliziumnitrid maskierten Gebieten das unreagierte Metall erhalten bleibt. Durch Verwendung einer entsprechenden Ätze werden das Metall und eventuell Reaktionsprodukte selektiv zum Metallsilizid entfernt, so daß das Metallsilizid nur auf der Gateelektrode und den Source/Draingebieten übrigbleibt. Mit diesem Verfahren wird eine Reduzierung der Schicht- und Kontaktwiderstände zur Verbesserung der Transistor-Performance erzielt. Der Salicide-Prozeß ist zum Beispiel in M. E. Alperin et al., IEEE Trans. Electron Devices, ED-32, 141 (1985), beschrieben.

Die Dotierstoffabreicherung findet beim Salicide-Prozeß sowohl in der Siliziumelektrode als auch in den Source/Draingebieten statt. Sie führt daher zu erhöhten Source/Drain-Kontaktwiderständen (siehe A. Mitwalsky et al., 6h Int. Symp. on Silicon Materials Science and Techn., ECS, Montreal, May 1990) und zur Ausbildung der Raumladungszone in der Gateelektrode. Diese Effekte reduzieren den Sättigungsdrainstrom, was zu einer Performanceeinbuße führt.

Da die Dotierstoffabreicherung in Anwesenheit von Bor besonders stark ist, tritt dieser Effekt vor allem bei Bor- oder BF₂-dotierten Gateelektroden und Source/Draingebieten auf (siehe C. Y. Wong et al. Techn. Dig. IEDM 88, pp. 238 bis 241 (1988) und R. A. Chapman et al. Techn. Dig. IEDM 88, pp. 52 bis 55 (1988)). Gateelektroden aus p⁺-dotiertem Polyzid und p-Kanal-Transistoren sind daher von der Dotierstoffabreicherung im Salicide-Prozeß besonders betroffen.

Aus der Literatur ist bekannt, die Dotierstoffabreicherung zum Beispiel durch Beschränkung des Temperaturbudgets (siehe H. Hayashida et al. Conf. Proc. VLSI Sym., pp. 29 bis 30 (1989)) oder durch eine Reduzierung der Siliziddicke (B. Davari et al. Techn. Dig. IEDM 88, pp. 56 bis 59 (1988)) zu unterbinden.

Eine Verringerung der Siliziddicke hat jedoch den Nachteil, daß sie sowohl die Leitfähigkeit in der Gateelektrode als auch die Temperaturbeständigkeit des Silizids (siehe R. Burmester et al., Conf. Proc. ESDERC 89, pp. 233 bis 36, Springer-Verlag, 1989, Eds.: Heuberger, Ryssel, Lange) verschlechtert.

Die Verringerung des Temperaturbudgets führt zu einer wesentlichen Einschränkung der Prozeßführung. Dies ist besonders nachteilig, da nur geringe Verbesserungen durch diese Maßnahme erzielbar sind.

Die Einführung einer als Diffusionsbarriere wirkenden Zwischenschicht zwischen der Siliziumschicht und der Metallsilizidschicht ist zur Unterdrückung der Dotierstoffabreicherung möglich. Das hat jedoch den Nachteil, einer deutlichen Erhöhung der Prozeßkomplexität und ist im Salicide-Prozeß auf die Gateelektrode beschränkt.

Der Erfindung liegt daher die Aufgabe zugrunde, ein Verfahren zur Herstellung einer dotierten Polyzidschicht anzugeben, bei dem die Dotierstoffabreicherung vermieden wird und das mit dem Salicide-Prozeß kompatibel ist.

Die Aufgabe wird erfindungsgemäß gelöst durch ein Verfahren nach Anspruch 1.

Der wesentliche Anteil der Dotierstoffabreicherung findet in den bekannten Verfahren während der Silizierungsreaktion statt. Daher wird in dem erfindungsgemäßen Verfahren die Dotierstoffabreicherung dadurch vermieden, daß die endgültige Dotierstoffverteilung in der Polyzidschicht durch die Implantation nach der Silizierungsreaktion festgelegt wird. Das hat den Vorteil, daß die Silizierungsreaktion ohne Einschränkungen durchgeführt wird.

Es liegt im Rahmen, die Siliziumschicht polykristallin oder amorph abzuscheiden.

Es liegt dabei im Rahmen der Erfindung, die Siliziumschicht vor der Erzeugung der Metallsilizidschicht mit einer Vordotierung zu versehen. Diese Ausführungsform ist besonders bei Verwendung von Bordotierung von Vorteil, da hier die maximal erzielbare Dotierung im Silizium aufgrund der relativ geringen Löslichkeit von Bor im Silizium ohnehin begrenzt ist.

Bei Anwendung dieser Ausführungsform zur Herstellung von p⁺-dotierten Polyzidgates wird eine Aufteilung der Borimplantation ermöglicht. Das hat den Vorteil, daß die Temperaturbelastung verteilt wird und damit die Gefahr des Bor-Penetration bei p⁺-dotierten Polyzidgates reduziert wird.

Zur Erzeugung der Metallsilizidschicht sind die bekannten Verfahren Co-Sputtern von Metall und Silizium, CVD-Abscheidung des Metallsilizids und Abscheidung des Metalls auf der Siliziumschicht mit anschließender Wärmebehandlung geeignet. Es ist besonders vorteilhaft, die Metallsilizidschicht durch Abscheidung einer Metallschicht auf der Siliziumschicht mit anschließender Wärmebehandlung zu erzeugen. Diese Reaktion läuft selektiv zwischen Metall und Silizium ab, so daß auf der Oberfläche der Siliziumschicht Bereiche, die nicht siliziert werden sollen, mit z. B. SiO₂ oder Si₃N₄ maskiert werden können.

Es liegt im Rahmen der Erfindung, das Verfahren in einem Salicide-Prozeß zur Herstellung eines MOS-Transistors anzuwenden. Source- und Draingebiete für den MOS-Transistor werden bei der Implantation nach der Silizierungsreaktion hergestellt. Bei der Silizierungsreaktion werden in dem Salicide-Prozeß, wie oben erörtert, sowohl die Gateelektrode als auch die Oberfläche der Source/Draingebiete siliziert. Da erfindungsgemäß die Implantation der Source/Draingebiete erst nach der Silizierungsreaktion erfolgt, wird auch eine Dotierstoffabreicherung der Source/Draingebiete vermieden.

Es liegt im Rahmen der Erfindung, das Herstellverfahren in einem Salicide-CMOS-Gesamtprozeß anzuwenden zur Erzeugung von n- und p-Kanal-Transistoren mit p⁺-dotierten Polyzidgates. In diesem Fall wird der n-Kanal-Transistor als buried-channel device und der p-Kanal-Transistor als surface-channel-MOSFET ausgeführt. Das führt zu einer wesentlichen Erhöhung der Transistorlebensdauer und ist daher für eine 5-Volt-Anwendung vorteilhaft einsetzbar.

Eine weitere Ausführungsform der Erfindung besteht in deren Anwendung in einem Salicide-CMOS-Gesamtprozeß zur Herstellung von n-Kanal-Transistoren mit n⁺-dotierten Polyzidgates und mit p-Kanal-Transistoren mit p⁺-dotierten Polyzidgates (sogenannte dual work function gates). In diesem Fall werden sowohl die n-Kanal-Transistoren als auch die p-Kanal-Transistoren als surface-channel MOSFETs hergestellt. Diese weisen ein ausgezeichnetes Kurzkanalverhalten auf. Diese Ausführungsform ist daher zur Herstellung von CMOS-Schaltungen mit Transistoren mit kurzer Gatelänge, die bei reduzierter Versorgungsspannung betrieben werden können, vorteilhaft einsetzbar.

Weitere Ausgestaltungen der Erfindung gehen aus den übrigen Ansprüchen hervor.

Im folgenden wird die Erfindung anhand der Ausführungsbeispiele und der Figuren näher erläutert.
Figur 1 bis Figur 3 stellt eine Prozeßfolge zur Herstellung einer dotierten Polyzidschicht dar.
Figur 4 bis Figur 10 stellt einen p⁺-Gate-Salicide-CMOS-Gesamtprozeß dar.
Figur 11 bis Figur 17 stellt einen n⁺/p⁺-Gate-Salicide-CMOS-Gesamtprozeß dar.

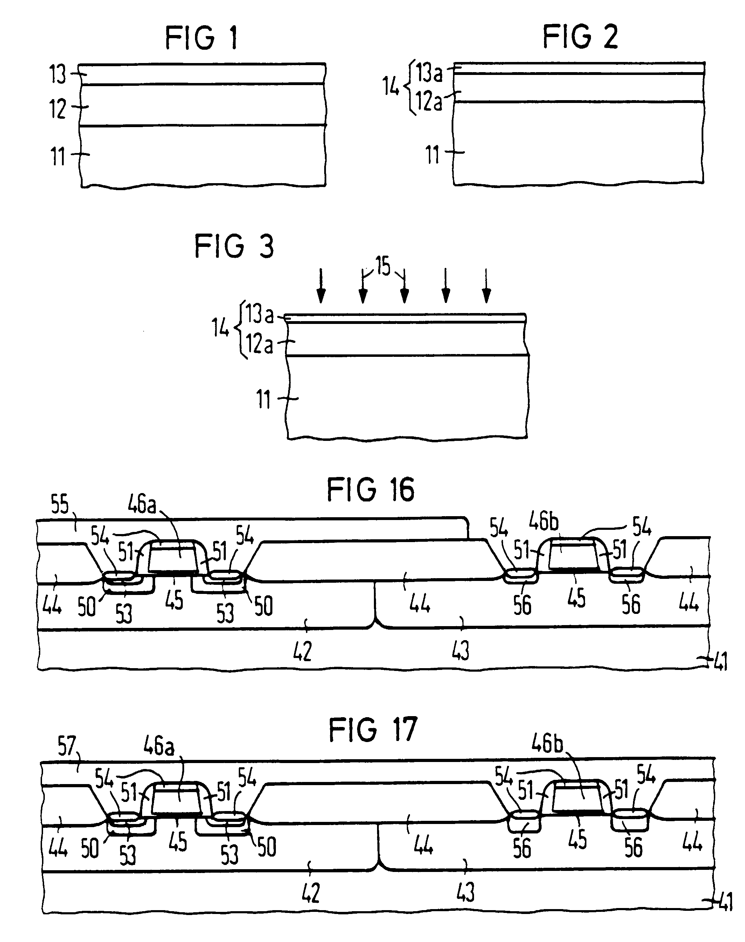

Auf ein Substrat 11 (siehe Figur 1) aus zum Beispiel monokristallinem Silizium wird eine Polysiliziumschicht 12 aufgebracht. Die Polysiliziumschicht 12 ist undotiert. Auf die Polysiliziumschicht 12 wird eine Metallschicht 13 aufgebracht, die zum Beispiel aus Titan, Tantal, Wolfram, Molybdän, Kobalt, Nickel oder Platin besteht. Die Polysiliziumschicht 12 weist eine Dicke von zum Beispiel 100 bis 500 nm auf. Die Metallschicht 13 wird in einer Dicke von z. B. 60 nm abgeschieden.

Bei einer Temperatur zwischen zum Beispiel 600 und 1000°C wird durch Reaktion zwischen dem Metall der Metallschicht 13 und einem Teil der Polysiliziumschicht 12 eine Metallsilizidschicht 13a gebildet (siehe Figur 2). Der verbleibende Teil der Polysiliziumschicht 12a bildet mit der Metallsilizidschicht 13a eine Polyzidschicht 14.

Es liegt im Rahmen der Erfindung, die Metallsilizidschicht 13a durch gleichzeitiges Sputtern des Metalls und des Siliziums mit nachfolgender Temperaturbehandlung zur Silizidbildung oder durch CVD-Abscheidung herzustellen.

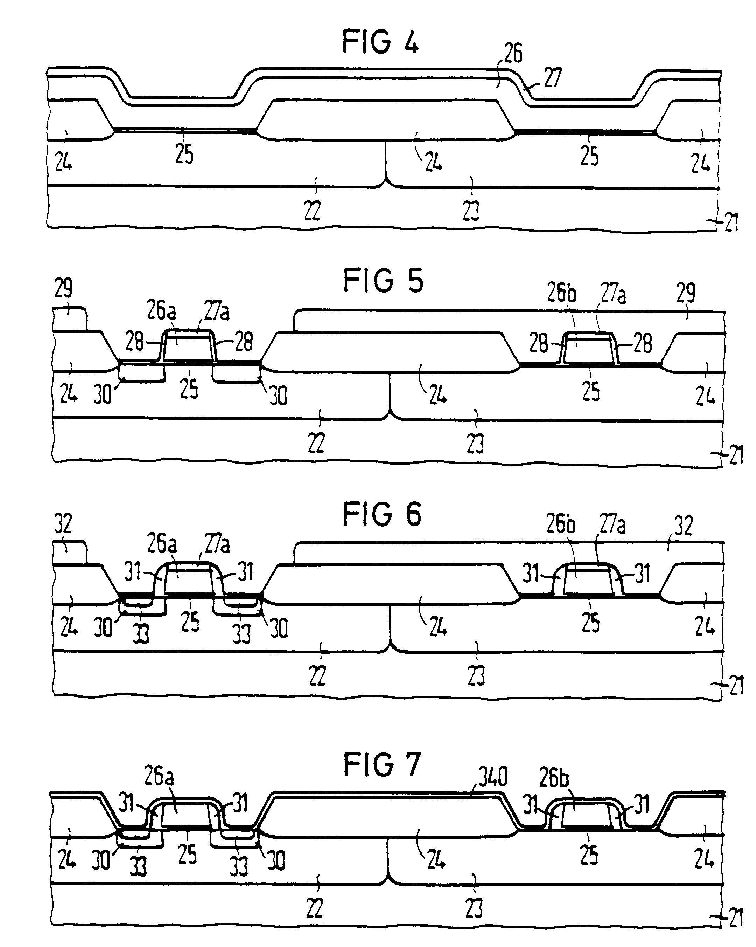

Nach der Bildung der Polyzidschicht 14 erfolgt die Dotierung der Polyzidschicht 14 durch Implantation, angedeutet durch das Bezugszeichen 15 in Figur 3. Besteht die Metallsilizidschicht 13a aus einem Metallsilizid, in dem eine starke Metall-Dotierstoffreaktion bei Hochtemperaturprozessen zu erwarten ist, wie dies zum Beispiel für TiSi₂ mit dem Dotierstoff Bor der Fall ist, muß die Implantation 15 mit einer solchen Energie erfolgen, daß Dotierstoffionen mindestens bis an die Grenzfläche der Polysiliziumschicht 12a zur Metallsilizidschicht 13a gelangen. In diesem Fall ist nämlich eine Ausdiffusion von Dotierstoff aus der Metallsilizidschicht 13a wegen der starken, konkurrierenden Metall-Dotierstoffreaktion unmöglich.

Es liegt im Rahmen der Erfindung, die Polysiliziumschicht 12 vor dem Abscheiden der Metallschicht 13 bzw. die Polysiliziumschicht 12a vor Erzeugung der Metallsilizidschicht 13a mit einer Vordotierung zu versehen. Es kommt zwar dann bei der Silizierungsreaktion zu einer Dotierstoffabreicherung der Polysiliziumschicht 12a, diese wird jedoch durch die nachfolgende Implantation 15 ausgeglichen. Das endgültige Dotierstoffprofil wird durch die Implantation 15 nach Bildung der Polyzidschicht 14 festgelegt.

In einem Substrat 21 (siehe Figur 4) aus zum Beispiel monokristallinem Silizium wird eine erste Wanne 22, die p-dotiert ist und eine zweite Wanne 23, die n-dotiert ist, erzeugt. Die erste Wanne 22 ist zum Beispiel mit Bor dotiert und weist eine Dotierstoffkonzentration von zum Beispiel 5 x 10¹⁶ cm⁻³ auf. Die zweite Wanne 23 ist zum Beispiel mit Phosphor dotiert und weist eine Dotierstoffkonzentration von 5 x 10¹⁶ cm⁻³ auf. Mit Hilfe von Feldoxidbereichen 24 werden in der ersten Wanne 22 ein erster Bereich zur Aufnahme eines ersten MOS-Transistors und in der zweiten Wanne 23 ein zweiter Bereich zur Aufnahme eines zweiten, zum ersten komplementären MOS-Transistors definiert. Die Feldoxidbereiche dienen zur Trennung der aktiven Transistoren. Die Feldoxidbereiche 24, die erste Wanne 22 und die zweite Wanne 23 werden zum Beispiel mit Hilfe von LOCOS-Technik hergestellt. Der erste MOS-Transistor wird als NMOS-Transistor und der zweite MOS-Transistor als PMOS-Transistor hergestellt.

An der Oberfläche der ersten Wanne 22 und der zweiten Wanne 23 wird in bekannter Weise eine Gateoxidschicht 25 erzeugt.

Es wird ganzflächig eine Polysiliziumschicht 26 abgeschieden. Die Polysiliziumschicht 26 wird in einer Dicke von zum Beispiel 100 bis 500 nm erzeugt und durch Implantation von zum Beispiel Bor p-dotiert. Die Implantation erfolgt dabei mit einer Energie von 15 keV und einer Dosis von 5 x 10¹⁵ cm⁻².

Auf die Polysiliziumschicht 26 wird eine Deckschicht 27 aus zum Beispiel Siliziumnitrid oder Siliziumoxid abgeschieden. Die Deckschicht 27 wird in einer Dicke von zum Beispiel 150 nm erzeugt.

Mit Hilfe einer nicht dargestellten Phototechnik werden die Deckschicht 27 und die Polysiliziumschicht 26 so strukturiert, daß aus der Polysiliziumschicht 26 eine erste Gateelektrode 26a für den ersten MOS-Transistor und eine zweite Gateelektrode 26b für den zweiten MOS-Transistor gebildet werden.

In einem Reoxidationsschritt werden die Flanken der ersten Gateelektrode 26a und der zweiten Gateelektrode 26b mit dünnen Flankenoxide 28 bedeckt. Es folgt die Erzeugung einer ersten Photolackmaske 29, die nur den ersten Bereich unbedeckt läßt (siehe Figur 5).

Mit Hilfe einer Implantation mit n-dotierenden Ionen, zum Beispiel mit Phosphor, werden LDD-Source/Draingebiete 30 für den ersten MOS-Transistor erzeugt. Dabei dient die erste Photolackmaske 29 und die erste Gateelektrode 26a als Implantationsmaske. Die Implantation von Phosphorionen in die erste Gateelektrode 26a wird dabei durch die Deckschicht 27a und die Flankenoxide 28 verhindert. Nach Entfernung der ersten Photolackmaske 29 (nicht dargestellt) werden an den Flanken der ersten Gateelektrode 26a und der zweiten Gateelektrode 26b Flankenbedeckungen 31 aus zum Beispiel Siliziumoxid erzeugt. Nach Erzeugung einer weiteren Photolackmaske 32, die wiederum nur den ersten Bereich unbedeckt läßt, werden durch Implantation mit Arsen hochdotierte Source/Draingebiete 33 für den ersten MOS-Transistor erzeugt. Da die Flankenbedeckungen 31 breiter sind als die Flankenoxide 28, ist die Ausdehnung der hochdotierten Source/Draingebiete 33 geringer als die der LDD-Source/Draingebiete 30 (siehe Figur 6).

Nach Entfernen der weiteren Photolackmasken wird die strukturierte Deckschicht 27a entfernt. Durch Anwendung einer Temperung nach Entfernen der weiteren Lackmaske 32 können die Source/Draingebiete 30, 33 aktiviert werden, was sich vorteilhaft auf die anschließende Silizierung auswirkt.

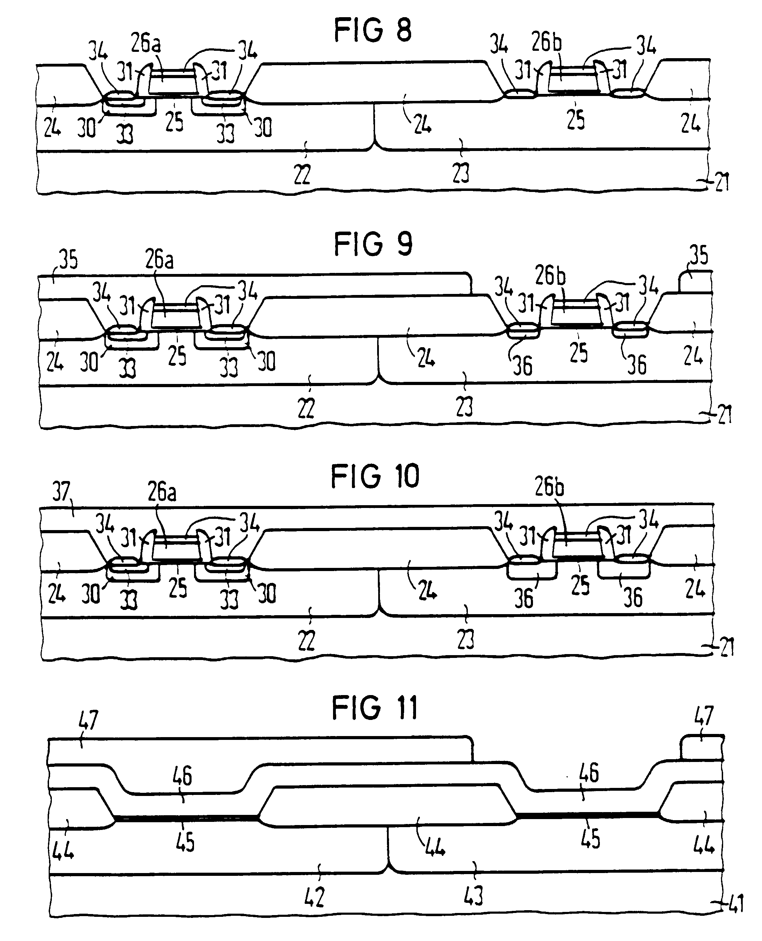

An der Ober fläche der ersten Gateelektrode 26a und der zweiten Gateelektrode 26b und an der Oberfläche der ersten Wanne 22 und der zweiten Wanne 23 wird durch Aufbringen einer Metallschicht 340 aus z. B. Titan (s. Fig. 7) und anschließender Temperaturbehandlung bei zum Beispiel 600 bis 1000°C Metallsilizid 34 erzeugt (siehe Figur 8). Dabei kommt es in der ersten Gateelektrode 26a und in der zweiten Gateelektrode 26b zu einer Dotierstoffabreicherung.

Unter Verwendung einer zweiten Photolackmaske 35, die nur den zweiten bereich unbedeckt läßt, als Implantationsmaske wird durch Implantation mit zum Beispiel Bor die Dotierstoffabreicherung in der zweiten Gateelektrode 26b kompensiert. Gleichzeitig werden Source/Draingebiete 36 für den zweiten MOS-Transistor implantiert (siehe Figur 9). Die Borimplantation erfolgt zum Beispiel mit einer Energie von 30 keV und einer Dosis von 5 x 10¹⁵ cm⁻². Die Borimplantation muß einerseits tief genug sein, um die Grenzfläche zwischen Metallsilizid und Polysilizium in der zweiten Gateelektrode 26b zu erreichen. Andererseits darf die Borimplantation nicht zu tief sein, damit die Source/Draingebiete 36 den Anforderungen für einen Kurzkanaltransistor entsprechen.

Durch die zweite Photolackmaske 35 wird die erste Gateelektrode 26a von der Implantation mit Bor abgeschirmt. In der ersten Gateelektrode 26a ist die Dotierstoffabreicherung unkritisch, da sich im ersten MOS-Transistor, der ein NMOS-FET ist, im Gegegensatz zum zweiten MOS-Transistor, der ein PMOS-FET ist, keine Raumladungszone in der Gateelektrode 26a ausbildet.

Nach Entfernung der zweiten Photolackmaske 35 wird ganzflächig eine Zwischenoxidschicht 37 (siehe Figur 10) aufgebracht. Es folgt eine Verfließtemperung zur Aktivierung des nachimplantierten Dotierstoffes. Die Verfließtemperung erfolgt zum Beispiel bei 900 °C.

In einem Substrat 41 aus zum Beispiel monokristallinem Silizium werden eine erste Wanne 42, die zum Beispiel p-dotiert ist, und eine zweite Wanne 43, die zum Beispiel n-dotiert ist, erzeugt. Die erste Wanne ist zum Beispiel mit Bor in einer Konzentration von 5 x 10¹⁶ cm⁻³ dotiert. Die zweite Wanne 43 ist zum Beispiel mit Phosphor in einer Dotierstoffkonzentration von 5 x 10¹⁶ cm⁻³ dotiert. Zur Trennung aktiver Transistorbereiche sind die Feldoxidbereiche 44 vorgesehen. Die Feldoxidbereiche 44 und die erste Wanne 42 und die zweite Wanne 43 sind zum Beispiel in LOCOS-Technologie hergestellt (siehe Figur 11).

Die erste Wanne 42 weist einen ersten Bereich auf, der von den Feldoxidbereichen 44 unbedeckt ist und der zur Aufnahme eines ersten MOS-Transistors bestimmt ist. Die zweite Wanne 43 weist einen zweiten Bereich auf, der von den Feldoxidbereichen 44 unbedeckt ist und der zur Aufnahme eines zweiten MOS-Transistors bestimmt ist. An der Oberfläche des ersten Bereichs sind Kanalimplantationen (nicht dargestellt) für den ersten MOS-Transistor, der ein NMOS-FET ist, vorgesehen. An der Oberfläche des zweiten Bereichs sind für den zweiten MOS-Transistor, der ein PMOS-FET ist, Kanalimplantationen vorgesehen.

Die freiliegende Oberfläche der ersten Wanne 42 und der zweiten Wanne 43 wird in bekannter Weise mit einer Gateoxidschicht 45 versehen.

Es wird ganzflächig eine undotierte Polysiliziumschicht 46 in einer Dicke von zum Beispiel 100 bis 500 nm abgeschieden.

Nach Erzeugung einer ersten Photolackmaske 47, die nur den zweiten bereich unbedeckt läßt, wird eine Implantation mit Bor mit einer Energie von zum Beispiel 15 keV und einer Dosis von zum Beispiel 5 x 10¹⁵ cm⁻² zur p-Dotierung der Polysiliziumschicht 46 durchgeführt.

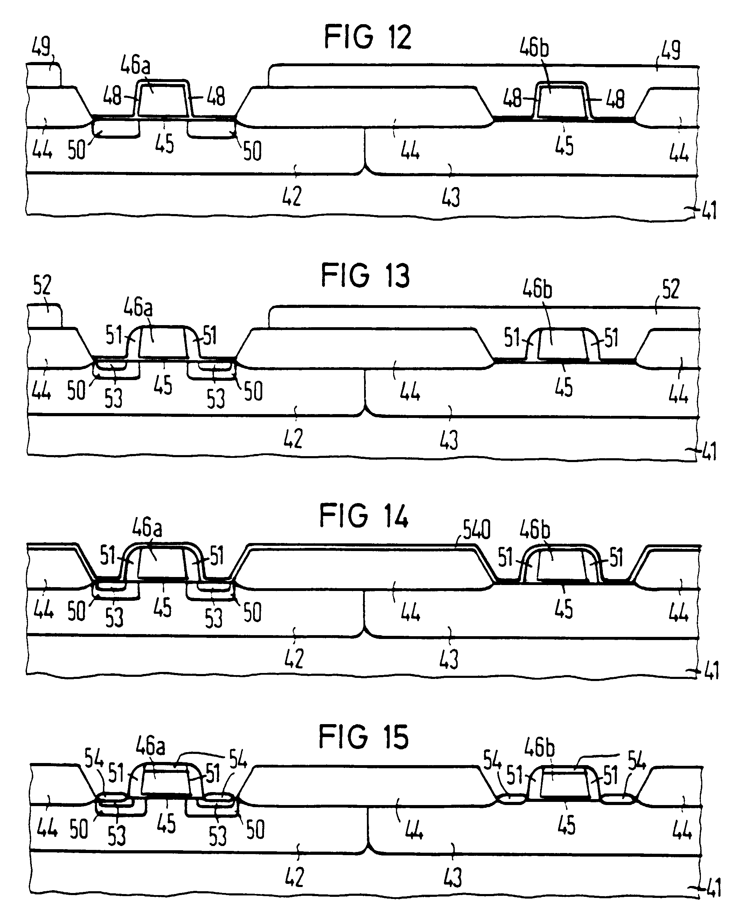

Nach Entfernung der ersten Photolackmaske 47 und Durchführung einer Phototechnik (nicht dargestellt) werden durch Strukturierung der Polysiliziumschicht 46 eine erste Gateelektrode 46a und eine zweite Gateelektrode 46b erzeugt. Die erste Gateelektrode 46a ist im Bereich des ersten MOS-Transistors angeordnet und besteht herstellungsgemäß aus undotiertem Polysilizium (siehe Figur 12). Die zweite Gateelektrode 46b liegt im Gebiet des zweiten MOS-Transistors und besteht herstellungsgemäß aus p⁺-dotiertem Polysilizium.

Mit Hilfe einer Reoxidation werden an den Flanken der ersten Gateelektrode 46a und der zweiten Gateelektrode 46b dünne Flankenoxide 48 erzeugt. Nach Bildung einer zweiten Photolackmaske 49, die nur den ersten Bereich unbedeckt läßt, erfolgt eine Implantation mit Phosphor zur Bildung von LDD-Source/Drain-Gebieten 50 für den ersten MOS-Transistor (siehe Figur 12). Die Implantation erfolgt zum Beispiel mit folgenden Parametern: Energie: 60 keV, Dosis: 3 x 10¹³ cm⁻².

Nach Entfernung der zweiten Photolackmaske 49 (nicht dargestellt) werden an den Flanken der ersten Gatelektrode 46a und der zweiten Gateelektrode 46b Flankenbedeckungen 51 aus zum Beispiel Siliziumoxid oder Siliziumnitrid erzeugt.

Nach Bildung einer weiteren Photolackmaske 52, die wiederum nur den ersten Bereich unbedeckt läßt, werden durch eine Arsenimplantation hochdotierte Source/Draingebiete 53 für den ersten MOS-Transistor hergestellt. Bei der Arsenimplantation wird die erste Gateelektrode 46a n⁺-dotiert (siehe Figur 13). Da die Ausdehnung der Flankenbedeckungen 51 größer ist als diejenige der Flankenoxide 48, weisen die hochdotierten Source/Draingebiete 53 eine andere Ausdehnung als die LDD-Source/Draingebiete 50 auf. Die Arsenimplantation erfolgt zum Beispiel mit folgenden Parametern: Energie: 50 keV, Dosis: 5 x 10¹⁵ cm⁻².

Es folgt die Entfernung der weiteren Photolackmaske 52. Es liegt im Rahmen der Erfindung, danach die Source/Draingebiete des ersten MOS-Transistors durch eine Temperung zu aktivieren. Dadurch verbessert sich die anschließende Silizierung.

Nachfolgend wird ganzflächig eine Metallschicht 540 aus zum Beispiel Titan aufgebracht (s. Fig. 14). Durch eine Wärmebehandlung bei zum Beispiel 600 bis 1000°C wird selektiv an den freiliegenden Siliziumflächen der ersten Wanne 42 und der zweiten Wanne 43 sowie an der Oberfläche der aus Polysilizium bestehenden ersten Gateelektrode 46a und der zweiten Gateelektrode 46b Metallsilizid 54, zum Beispiel TiSi₂, erzeugt (siehe Figur 15). Bei der Silizierungsreaktion kommt es in der zweiten Gateelektrode 46b zu einer Dotierstoffabreicherung infolge der Metall-Dotierstoffreaktion zwischen Titan und Bor. In der ersten Gateelektrode 46a findet eine solche Metall-Dotierstoffreaktion zwischen Arsen und Titan nicht in merklichem Ausmaß statt, so daß hier nicht von einer Dotierstoffabreicherung gesprochen werden kann.

Nach Erzeugung einer dritten Photolackmaske 55, die nur den zweiten Bereich unbedeckt läßt, erfolgt eine Bor-Implantation zur Kompensierung der Dotierstoffabreicherung in der zweiten Gateelektrode 46b. Gleichzeitig werden bei der Implantation mit Bor Source/Draingebiete 56 für den zweiten MOS-Transistor hergestellt. Die Borimplantation erfolgt zum Beispiel mit folgenden Parametern: Energie: 30 keV, Dosis: 5 x 10¹⁵ cm⁻²
Bei der Implantation mit Bor ist darauf zu achten, daß der Dotierstoff mindestens bis an die Grenzfläche zwischen Metallsilizid 54 und Polysilizium in der zweiten Elektrode 46b gelangt. Wegen der starken Metalldotierstoffreaktion ist nämlich eine spätere Ausdiffusion von Bor aus dem Metallsilizid 54 in das Polysilizium nicht möglich. Andererseits muß die Borimplantation so geführt werden, daß die Source/Draingebiete 56 den Anforderungen an den zweiten MOS-Transistor genügen (s. Fig. 16).

Nach Entfernung der dritten Photolackmaske 55 wird ganzflächig eine Zwischenoxidschicht 57 erzeugt (siehe Figur 17) und die Struktur einer Verfließtemperung bei zum Beispiel 900 °C unterzogen. Bei der Verfließtemperung werden die Source/Draingebiete 56 des zweiten MOS-Transistors aktiviert. Falls nicht schon erfolgt werden die hochdotierten Source/Draingebiete 53 und die LDD-Source/Draingebiete 50 des ersten MOS-Transistors in diesem Schritt ebenfalls aktiviert.

Der Herstellprozeß wird in bekannter Weise mit Kontaktlochätzung und Metallisierungen beendet.

## Patentansprüche

1. Verfahren zur Herstellung mindestens eines MOS-Transistors in einem Salicide-Prozeß,
- bei dem auf einem Substrat (21,41) aus Silizium eine Isolationsschicht (25,45) erzeugt wird,
- bei dem auf die Isolationsschicht eine nicht-einkristalline Siliziumschicht (26,46) aufgebracht und vordotiert wird,
- bei dem die Siliziumschicht und die Isolationsschicht so strukturiert werden, daß sie gemeinsame Flanken aufweisen, die mit isolierenden Flankenbedeckungen (31,51) versehen werden,
- bei dem maskierende Strukturen (24,44) erzeugt werden, von denen die Oberfläche der strukturierten Siliziumschicht und des Substrates in Bereichen, in denen später Source/Drain-Gebiete gebildet werden, unbedeckt bleibt,
- bei dem ganzflächig eine Metallschicht (340,540) abgeschieden wird,
- bei dem mit Hilfe einer Wärmebehandlung ein Teil der strukturierten Siliziumschicht und die Oberfläche des Substrates in den späteren Source/Drain-Gebieten durch Reaktion mit der darauf angeordneten Metallschicht in Metallsilizid umgewandelt wird,
- bei dem die maskierenden Strukturen und die Flankenbedeckungen aus einem Material gebildet werden, das bei der Wärmebehandlung mit der Metallschicht nicht zu Metallsilizid reagiert,
- bei dem mit Hilfe einer Implantation die aus der strukturierten Siliziumschicht und dem darauf gebildeten Metallsilizid bestehende Polyzidschicht auf einen Endwert der Dotierstoffkonzentration dotiert wird und gleichzeitig die Source/Drain-Gebiete in dem Substrat gebildet werden.

2. Verfahren nach Anspruch 1, bei dem die Siliziumschicht als Polysiliziumschicht erzeugt wird.

3. Verfahren nach Anspruch 1 oder 2, bei dem die Metallschicht mindestens eines der Metalle Titan, Tantal, Wolfram, Molybdän, Kobalt, Nickel und Platin enthält.

4. Verfahren nach einem der Ansprüche 1 bis 3, bei dem die maskierenden Strukturen (24, 44) und die Flankenbedeckungen (31, 51) mindestens eines der Materialien Siliziumoxid und Siliziumnitrid enthalten.

5. Verfahren nach einem der Ansprüche 1 bis 4, mit folgenden Schritten:
a) in dem Substrat (21) werden eine erste Wanne (22) eines ersten Leitfähigkeitstyps und eine zweite Wanne (23) eines zweiten, zum ersten entgegengesetzten Leitfähigkeitstyps erzeugt,
b) mit Hilfe von Feldoxidbereichen (24) als die mashierenden Strukturen werden in der ersten Wanne (22) ein erster Bereich zur Aufnahme eines ersten MOS-Transistors und in der zweiten Wanne (23) ein zweiter Bereich zur Aufnahme eines zweiten, zum ersten komplementären MOS-Transistors definiert,
c) nach Erzeugung einer Gateoxidschicht (25) als die Isolationsschicht an der Oberfläche des ersten Bereiches und des zweiten Bereiches wird ganzflächig eine vom ersten Leitfähigkeitstyp dotierte Polysiliziumschicht (26) als die nicht-einkristalline Siliziumschicht und darauf eine Deckschicht (27) erzeugt, die mindestens eines der Materialien Siliziumoxid und Siliziumnitrid enthält,
d) nach Bildung einer ersten Gateelektrode (26b) für den ersten MOS-Transistor und einer zweiten Gateelektrode (26b) für den zweiten MOS-Transistor nach Strukturierung der Polysiliziumschicht (26) und nach Bildung von den Flankenbedeckungen an den Flanken der ersten Gateelektrode (26a) und der zweiten Gateelektrode (26b) wird eine erste Photolackmaske (29) erzeugt, die nur den ersten Bereich unbedeckt läßt,
e) nach Bildung erster Source- und Drain-Gebiete (33) für den ersten MOS-Transistor durch Implantation von vom zweiten Leitfähigkeitstyp dotierenden Ionen unter Verwendung der ersten Gateelektrode (26a) und der ersten Photolackmaske (29) als Implantationsmaske wird die erste Photolackmaske (29) entfernt,
f) nach Entfernung der Deckschicht (27) wird ganzflächig die Metallschicht (340) aufgebracht und die Wärmebehandlung zur Metallsilizidbildung durchgeführt,
g) unter Verwendung einer zweiten Photolackmaske (35), die nur den zweiten Bereich unbedeckt läßt, als Implantationsmaske wird eine Implantation mit vom ersten Leitfähigkeitstyp dotierenden Ionen zur Einstellung eines Endwertes der Dotierstoffkonzentration in der zweiten Gateelektrode (26b) und zur Bildung von zweiten Source/Drain-Gebieten (36) für den zweiten MOS-Transistor durchgeführt,
h) nach Entfernung der zweiten Photolackmaske (35) wird ganzflächig eine Zwischenoxidschicht erzeugt.

6. Verfahren nach einem der Ansprüche 1 bis 4, mit folgenden Schritten:
a) in dem Substrat (41) werden eine erste Wanne (42) eines ersten Leitfähigkeitstyps und eine zweite Wanne (43) eines zweiten, zum ersten entgegengesetzten Leitfähigkeitstyps erzeugt,
b) mit Hilfe von Feldoxidbereichen (44) als die mashierenden Strukturen werden in der ersten Wanne (42) ein erster Bereich zur Aufnahme eines ersten MOS-Transistors und in der zweiten Wanne (43) ein zweiter Bereich zur Aufnahme eines zweiten, zum ersten komplementären MOS-Transistors definiert,
c) nach Erzeugung einer Gateoxidschicht (45) als die Isolationsschicht an der Oberfläche des ersten Bereichs und des zweiten Bereichs wird ganzflächig eine Polysiliziumschicht (46) als die nicht-einkristalline Siliziumschicht erzeugt, die unter Verwendung einer ersten, nur den zweiten Bereich unbedeckt lassenden Photolackmaske (47) als Implantationsmaske durch Implantation im zweiten Bereich vom ersten Leitfähigkeitstyp dotiert wird,
d) nach Entfernung der ersten Photolackmaske (47) und Bildung einer ersten Gateelektrode (46a) für den ersten MOS-Transistor und einer zweiten Gateelektrode (46b) für den zweiten MOS-Transistor durch Strukturierung der Polysiliziumschicht (46) und nach Bildung von den Flankenbedeckungen (51) an den Flanken der ersten Gateelektrode (46a) und der zweiten Gateelektrode (46b) wird eine zweite Photolackmaske (49) erzeugt, die nur den ersten Bereich unbedeckt läßt,
e) nach Bildung erster Source- und Drain-Gebiete (53) für den ersten MOS-Transistor und Dotierung der ersten Gateelektrode (46a) durch Implantation von vom zweiten Leitfähigkeitstyp dotiertenden Ionen unter Verwendung der zweiten Photolackmaske (49) als Implantationsmaske wird die zweite Photolackmaske (49) entfernt,
f) nach ganzflächigem Aufbringen der Metallschicht (540) wird die Wärmebehandlung zur Metallsilizidbildung durchgeführt,
g) unter Verwendung einer dritten Photolackmaske (55) die nur den zweiten Bereich unbedeckt läßt als Implantationsmaske wird eine Implantation von vom ersten Leitfähigkeitstyp dotierenden Ionen zur Einstellung eines Endwertes der Dotierstoffkonzentration der zweiten Gateelektrode und zur Bildung von zweiten Source- und Drain-Gebieten (56) für den zweiten MOS-Transistor durchgeführt,
h) nach Entfernung der dritten Photolackmaske (55) wird ganzflächig eine Zwischenoxidschicht (57) erzeugt.

7. Verfahren nach Anspruch 5 oder 6, bei dem die Implantation der ersten Source- und Drain-Gebiete (30, 33, 50, 53) in zwei Schritten mit einem LDD-Profil erfolgt.

8. Verfahren nach einem der Ansprüche 5 bis 7, bei dem vor der Erzeugung der Flankenbedeckungen (51) unter Verwendung einer weiteren, nur den zweiten Bereich unbedeckt lassenden Photolackmaske als Implantationsmaske durch Implantation mit vom ersten Leitfähigkeitstyp dotierenden Ionen eine LDD-Implantation des zweiten Source- und Drain-Gebietes erzeugt wird.

9. Verfahren nach einem der Ansprüche 5 bis 8, bei dem vom ersten Leitfähigkeitstyp dotierte Bereiche mit einem der Dotierstoffe Bor und BF₂ dotiert werden.

## Claims

1. Method for producing at least one MOS transistor in a salicide process,
- in which an insulating layer (25,45) is produced on a substrate (21,41),
- in which a non-monocrystalline silicon layer (26,46) is deposited on the insulating layer and predoped,
- in which the silicon layer and the insulating layer are structured in such a way that they have common edges which are provided with insulating edge coverings (31,51),
- in which masking structures (24,44) are produced, the surface of the structured silicon layer of which and of the substrate in regions in which source and drain regions are later formed remains uncovered,
- in which a metal layer (340,540) is deposited over the entire surface,
- in which, with the aid of a heat treatment, some of the structured silicon layer and the surface of the substrate in the later source and drain regions are converted into metal silicide by reaction with the metal layer disposed thereon,
- in which the masking structures and the edge coverings are formed from a material which does not react with the metal layer to form metal silicide during the heat treatment,
- in which, with the aid of an implantation, the polycide layer comprising the structured silicon layer and the metal silicide formed thereon is doped to a final value of the dopant concentration and at the same time the source and drain regions in the substrate are formed.

2. Method according to Claim 1, in which the silicon layer is produced as a polysilicon layer.

3. Method according to Claim 1 or 2, in which the metal layer contains at least one of the metals titanium, tantalum, tungsten, molybdenum, cobalt, nickel and platinum.

4. Method according to one of Claims 1 to 3, in which the masking structures (24,44) and the edge coverings (31,51) contain at least one of the materials silicon oxide and silicon nitride.

5. Method according to Claim 1 to 4, comprising the following steps:
a) a first tub (22) of a first conductivity type and a second tub (23) of a second conductivity type opposite to the first are produced in the substrate (21),
b) with the aid of field oxide regions (24) as the masking structures, a first region for receiving a first MOS transistor is defined in the first tub (22) and a second region for receiving a second MOS transistor complementary to the first is defined in the second tub (23),
c) after a gate oxide layer (25) has been produced as the insulating layer at the surface of the first region and of the second region, a doped polysilicon layer (26) of the first conductivity type is produced as the non-monocrystalline silicon layer over the entire surface, and a covering layer (27) is produced thereon which contains at least one of the materials silicon oxide and silicon nitride,
d) after forming a first gate electrode (26b) for the first MOS transistor and a second gate electrode (26b) for the second MOS transistor after structuring the polysilicon layer (26) and after forming the edge coverings (31) at the edges of the first gate electrode (26a) and of the second gate electrode (26b), a first photoresist mask (29) is produced which leaves only the first region uncovered,
e) after forming first source and drain regions (33) for the first MOS transistor by implantation of doping ions of the second conductivity type using the first gate electrode (26a) and the first photoresist mask (29) as implantation mask, the first photoresist mask (29) is removed,
f) after removing the covering layer (27), the metal layer (340) is deposited over the entire surface and the heat treatment is carried out to form metal silicide,
g) using a second photoresist mask (35) which leaves only the second region uncovered as implantation mask, an implantation with doping ions of the first conductivity type is carried out to adjust a final value of the dopant concentration in the second gate electrode (26b) and to form second source/drain regions (36) for the second MOS transistor,
h) after the second photoresist mask (35) has been removed, an intermediate oxide layer (37) is produced over the entire surface.

6. Method according to Claim 1 to 4, comprising the following steps:
a) a first tub (42) of a first conductivity type and a second tub (43) of a second conductivity type opposite to the first are produced in the substrate (41),
b) with the aid of field oxide regions (44) as the masking structures, a first region is defined in the first tub (42) to receive a first MOS transistor and a second region is defined in the second tub (43) to receive a second MOS transistor complementary to the first,
c) after producing a gate oxide layer (45) as the insulating layer at the surface of the first region and of the second region, a polysilicon layer (46) is formed, as the non-monocrystalline silicon layer, over the entire surface which polysilicon layer (46) is doped using a first photoresist mask (47) which leaves only the second region uncovered as implantation mask by implementation in the second region of the first conductivity type,
d) after removing the first photoresist mask (47) and forming a first gate electrode (46a) for the first MOS transistor and a second gate electrode (46b) for the second MOS transistor by structuring the polysilicon layer (46) and after forming the edge coverings (51) at the edges of the first gate electrode (46a) and of the second gate electrode (46b), a second photoresist mask (49) is produced which leaves only the first region uncovered,
e) after forming first source and drain regions (53) for the first MOS transistor and doping the first gate electride (46a) by implantation of doping ions of the second conductivity type using the second photoresist mask (49) as implantation mask, the second photoresist mask (49) is removed,
f) after removing the metal layer (540) over the entire surface, the heat treatment to form metal silicide is carried out,
g) using a third photoresist mask (55) which leaves only the second region uncovered as implantation mask, an implantation of doping ions of the first conductivity type is carried out to adjust a final value of the dopant concentration of the second gate electrode and to form second source and drain regions (56) for the second MOS transistor,
h) after the third photoresist mask (55) has been removed, an intermediate oxide layer (57) is produced over the entire surface.

7. Method according to Claim 5 or 6, in which the implantation of the first source and drain regions (30, 33, 50, 53) is carried out in two steps with an LDD profile.

8. Method according to one of Claims 5 to 7, in which an LDD implantation of the second source and drain regions is produced before the production of the edge coverings (51) using a further photoresist mask which leaves only the second region uncovered as implantation mask by implantation with dopins ions of the first conductivity type.

9. Method according to one of Claims 5 to 8, in which doped regions of the first conductivity type are doped with one of the dopants boron and BF₂.

## Revendications

1. Méthode de fabrication d'au moins un transistor MOS selon un procédé Salicide
- dans laquelle une couche isolante (25, 45) est créée sur un substrat (21, 41) en silicium,
- dans laquelle une couche de silicium non monocristalline (26, 46) est appliquée sur la couche isolante et est prédopée,
- dans laquelle la couche de silicium et la couche isolante sont structurées de sorte qu'elles présentent des flancs communs qui sont dotés de recouvrements de flancs isolants (31, 51),
- dans laquelle sont créées des structures de masquage (24, 44) dont la surface de la couche de silicium structurée et du substrat n'est pas revêtue dans des zones où seront formées plus tard des régions de la source / du drain,
- dans laquelle une couche métallique (340, 540) est déposée sur toute la surface,
- dans laquelle, grâce à un traitement thermique, une partie de la couche de silicium structurée et la surface du substrat est transformée en siliciure métallique dans les futures régions de la source / du drain par réaction avec la couche métallique appliquée par-dessus,
- dans laquelle les structures de masquage et les recouvrements de flancs sont formés dans un matériau qui, lors du traitement thermique, ne forme pas de siliciure métallique par réaction avec la couche métallique,
- dans laquelle, à l'aide d'une implantation, la couche de polycide constituée de la couche de silicium structurée et du siliciure métallique formé par-dessus est dopée à une valeur finale de concentration d'agent de dopage et dans le même temps les régions de la source / du drain sont formées dans le substrat.

2. Méthode selon la revendication 1 dans laquelle la couche de silicium est créée comme couche de silicium polycristallin.

3. Méthode selon la revendication 1 ou 2 dans laquelle la couche métallique contient au moins un des métaux titane, tantale, tungstène, molybdène, cobalt, nickel et platine.

4. Méthode selon l'une des revendications 1 à 3 dans laquelle les structures de masquage (24, 44) et les recouvrements des flancs (31, 51) contiennent au moins un des matériaux oxyde de silicium et nitrure de silicium.

5. Méthode selon l'une des revendications 1 à 4 comportant les étapes suivantes :
a) une première cuve (22) d'un premier type de conductivité et une deuxième cuve (23) d'un deuxième type de conductivité opposé au premier sont créées dans le substrat (21),
b) à l'aide de zones d'oxydes de champ (24) servant de structures de masquage, une première zone destinée à recevoir un premier transistor MOS est définie dans la première cuve (22) et une deuxième zone destinée à recevoir un deuxième transistor MOS complémentaire au premier est définie dans la deuxième cuve (23),
c) après avoir créé une couche d'oxyde de grille (25) servant de couche isolante à la surface de la première zone et de la deuxième zone, une couche de silicium polycristallin (26) dopée du premier type de conductivité devant constituer la couche de silicium non monocristalline est créée sur toute la surface ainsi que, par-dessus, une couche de recouvrement (27) qui contient au moins un des matériaux oxyde de silicium et nitrure de silicium,
d) après formation d'une première électrode de grille (26b) pour le premier transistor MOS et d'une deuxième électrode de grille (26b) pour le deuxième transistor de grille après structuration de la couche de silicium polycristallin (26) et après formation des recouvrements des flancs sur les flancs de la première électrode de grille (26a) et de la deuxième électrode de grille (26b), on crée un premier masque de photorésist (29) qui laisse uniquement la première zone à nu,
e) après formation de premières régions de la source et du drain (33) pour le premier transistor MOS par implantation d'ions dopants du deuxième type de conductivité en utilisant la première électrode de grille (26a) et le premier masque de photorésist (29) comme masque d'implantation, le premier masque de photorésist (29) est enlevé,
f) après enlèvement de la couche de recouvrement (27), la couche métallique (340) est appliquée sur toute la surface et le traitement thermique est réalisé pour former le siliciure métallique,
g) en utilisant un deuxième masque de photorésist (35), qui laisse uniquement la deuxième zone à nu, comme masque d'implantation, une implantation est réalisée à l'aide d'ions dopants du premier type de conductivité pour régler une valeur finale de la concentration en agents de dopage dans la deuxième électrode de grille (26b) et pour former des deuxièmes régions de la source / du drain (36) pour le deuxième transistor MOS,
h) après enlèvement du deuxième masque de photorésist (35), une couche d'oxyde intermédiaire est créée sur toute la surface.

6. Méthode selon l'une des revendications 1 à 4 comportant les étapes suivantes :
a) une première cuve (42) d'un premier type de conductivité et une deuxième cuve (43) d'un deuxième type de conductivité opposé au premier sont créées dans le substrat (41),
b) à l'aide de zones d'oxydes de champ (44) servant de structures de masquage, une première zone destinée à recevoir un premier transistor MOS est définie dans la première cuve (42) et une deuxième zone destinée à recevoir un deuxième transistor MOS complémentaire au premier est définie dans la deuxième cuve (43),
c) après avoir créé une couche d'oxyde de grille (45) servant de couche isolante à la surface de la première zone et de la deuxième zone, une couche de silicium polycristallin (46) devant constituer la couche de silicium non monocristalline est créée sur toute la surface, laquelle est dopée en utilisant un premier masque de photorésist (47) qui, comme masque d'implantation laisse uniquement la deuxième zone à nu, par implantation dans la deuxième zone du premier type de conductivité,
d) après enlèvement du premier masque de photorésist (47) et formation d'une première électrode de grille (46a) pour le premier transistor MOS et d'une deuxième électrode de grille (46b) pour le deuxième transistor MOS par structuration de la couche de silicium polycristallin (46) et après formation des recouvrements de flancs (51) aux flancs de la première électrode de grille (46a) et de la deuxième électrode de grille (46b), on crée un deuxième masque de photorésist (49) qui laisse uniquement la première zone à nu,
e) après formation de premières régions de la source et du drain (53) pour le premier transistor MOS et dopage de la première électrode de grille (46a) par implantation d'ions dopants du deuxième type de conductivité en utilisant le deuxième masque de photorésist (49) comme masque d'implantation, le deuxième masque de photorésist (49) est enlevé;
f) après application de la couche métallique (540) sur toute la surface, le traitement thermique destiné à la formation de siliciure de métal est réalisé,
g) en utilisant un troisième masque de photorésist (55), qui laisse uniquement la deuxième zone à nu, comme masque d'implantation, une implantation est réalisée à l'aide d'ions dopants du premier type de conductivité pour régler une valeur finale de la concentration en agents de dopage dans la deuxième électrode de grille et pour former des deuxièmes régions de la source / du drain (56) pour le deuxième transistor MOS,
h) après enlèvement du troisième masque de photorésist (55), une couche d'oxyde intermédiaire (57) est créée sur toute la surface.

7. Méthode selon la revendication 5 ou 6, dans laquelle l'implantation des premières régions de la source et du drain (30, 33, 50, 53) s'effectue en deux phases avec un profil LDD.

8. Méthode selon l'une des revendications 5 à 7 dans laquelle, avant de réaliser les recouvrements des flancs (51) en utilisant, comme masque d'implantation, un autre masque de photorésist qui laisse uniquement la deuxième zone à nu par implantation d'ions dopants du premier type de conductivité, on crée une implantation LDD de la deuxième région de la source et du drain.

9. Méthode selon l'une des revendications 5 à 8 dans laquelle les zones dopées par le premier type de conductivité sont dopées avec l'un des agents de dopage bore et BF₂.
